Europäisches Patentamt

European Patent Office

Office européen des brevets

Veröffentlichungsnummer: **0 283 566**
**A1**

## EUROPÄISCHE PATENTANMELDUNG

(21) Anmeldenummer: **87116233.5**

(51) Int. Cl.⁴: **H05K 1/00**

(22) Anmeldetag: **04.11.87**

(30) Priorität: **14.03.87 DE 3708417**

(43) Veröffentlichungstag der Anmeldung:
**28.09.88 Patentblatt 88/39**

(84) Benannte Vertragsstaaten:
**DE FR GB SE**

(71) Anmelder: **VDO Adolf Schindling AG**
**Gräfstrasse 103**
**D-6000 Frankfurt/Main(DE)**

(72) Erfinder: **Göttert, Thomas**
**Rüdesheimerstrasse 12**
**D-6200 Wiesbaden(DE)**

(74) Vertreter: **Klein, Thomas, Dipl.-Ing. (FH)**
**Sodener Strasse 9 Postfach 6140**
**D-6231 Schwalbach a. Ts.(DE)**

(54) **Leiterplatte.**

(57) Eine Leiterplatte ist mit einer elektrisch leitenden Masseschicht (4) versehen. Von ihr sind Signalleitungen (2,1 ) und sonstige Leiterbahnen durch schmale Trennfugen (6) getrennt. Dadurch werden elektromagnetische Einwirkungen von außen auf die Schaltung vermieden.

Fig. 4

EP 0 283 566 A1

## Leiterplatte

Die Erfindung bezieht sich auf eine Leiterplatte mit Signalleitungen und Versorgungsleitungen. Solche Leiterplatten sind in elektronischen Einrichtungen erforderlich und deshalb allgemein bekannt.

Bei elektronischen Schaltungen höherer Integration besteht grundsätzlich das Problem hochfrequenter Störungen und Spikes, welche auf die zur Schaltung führenden Leitungen einwirken und zu erheblichen Funktionsstörungen bis hin zum totalen Systemausfall führen können. Freilaufende Leiterbahnen wirken als Antenne und nehmen hochfrequente Energie auf, die sie als Antenne an Nachbarleitungen wieder abgeben, da sie mit diesen wiederum über parasitäre Kapazitäten verkoppelt sind.

Störungen unter 10 MHz lassen sich recht gut durch billige Keramikkondensatoren abblocken, in höheren Frequenzbereichen wären aber nur sehr teure Bauelemente wirksam.

Bei Leiterplatten ist es zur Vermeidung von elektromagnetischen Einwirkungen von außen - schon bekannt, parallel zu wichtigen Signalleitungen Massebahnen zu führen, damit hochfrequente Störsignale mit niedriger Impedanz nach Masse abgeleitet werden können. Solche Maßnahmen sind relativ teuer und oftmals aus Platzgründen auf der Leiterplatte nicht durchführbar.

Der Erfindung liegt die Aufgabe zugrunde, eine Leiterplatte mit Signalleitungen und Versorgungsleitungen derart zu gestalten, daß elektromagnetische Einwirkungen mit möglichst geringem Aufwand zuverlässig ausgeschlossen werden können.

Diese Aufgabe wird auf überraschend einfache Weise dadurch gelöst, daß alle nicht für die Signalleitungen und Versorgungsleitungen benötigten Flächen mit einer Masseschicht belegt sind.

Bei einer solchen erfindungsgemäßen Leiterplatte könnte man von einem "Invers-Layout" sprechen. Während bei üblichen Leiterplatten der Hintergrund nichtleitend ist, besteht er gemäß der Erfindung aus leitendem Material. Dadurch werden elektromagnetische Einwirkungen von außen zuverlässig ausgeschlossen. Gemäß der Erfindung wird die Aufgabe des Abblockens hochfrequenter Störungen in den Bereich des Layouts verlagert. Dadurch läßt sich mit einfachen Layoutmaßnahmen der Entstörungsgrad erheblich verbessern. Dies ist auf parasitäre Kondensatoren zurückzuführen, die bei parallel zur Masse oder auch einem anderen festen Bezugspotential verlaufenden Leiterbahnen entstehen. Diese parasitären Kapazitäten liegen im unteren pF-Bereich bei etwa 5 pF/cm und dämpfen die Hochfrequenz in Abhängigkeit von der Frequenz und des Generatorinnenwiderstandes.

Von Vorteil ist es, wenn die Signalleitungen und Versorgungsleitungen durch sie umgebende Trennfugen in der Masseschicht erzeugt sind.

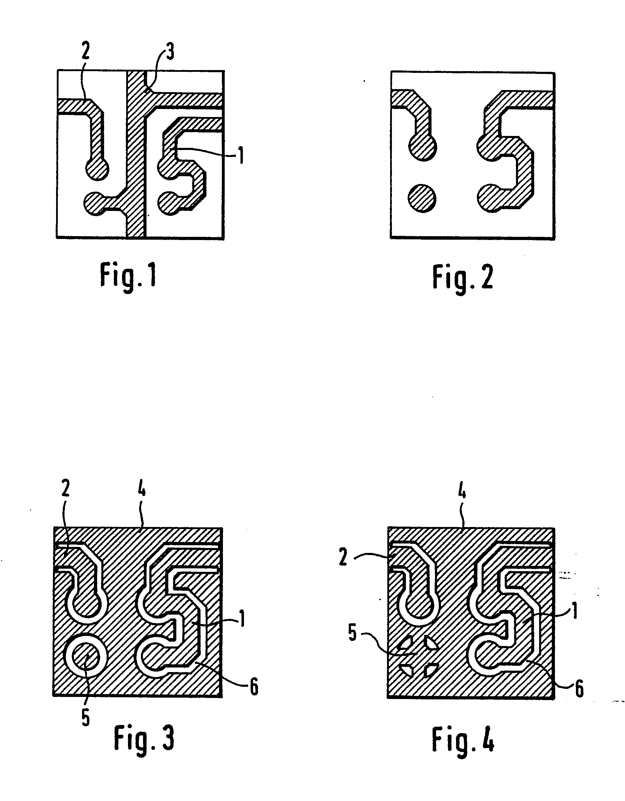

Die Erfindung läßt verschiedene Ausführungsformen zu. Zu ihrer weiteren Verdeutlichung wird nachfolgend das Entstehen einer erfindungsgemäßen Leiterplatte anhand der Zeichnung erläutert. Diese zeigt in den Figuren 1 bis 4 das Layout in verschiedenen Herstellungsstufen.

Die Figur 1 zeigt, daß zunächst ein Layout nach den bekannten Regeln der elektromagnetischen Verträglichkeit erstellt wird. Hierbei werden auch die erforderlichen Masse-Verbindungen berücksichtigt. Dadurch wird sichergestellt, daß im fertigen Layout durch die inversen Masseflächen alle Massepunkte der Schaltung erreicht werden. Zusätzlich muß bei der Entflechtung darauf geachtet werden, daß keine "Inseln", also nicht mit Masse verbundenen Flächen entstehen. Zu sehen sind in der Figur 1 zwei Signalleitungen 1, 2 und eine Masseverbindung 3.

Figur 2 zeigt, daß nach dem Abschluß der Entflechtung alle Massebahnen aus dem Layout herausgenommen werden.

Zum in Figur 3 dargestellten Layout-Zustand kommt man, indem anschließend inverse Masseflächen 4 hinzugefügt werden, die zu allen Signalleitungen 1, 2 und sonstigen Leiterbahnen sowie Lötaugen 5 einen Abstand von 0,3 mm einhalten, so daß die Signalleitungen 1, 2 jeweils durch eine Fuge 6 von der Massefläche 4 getrennt sind. Bei einer CAD-Anlage kann dies durch entsprechende Bearbeitung der grafischen Daten des Layouts sehr einfach erreicht werden. In Klebetechnik erstellte Unterlagen müssen auf fotografischem Wege und durch Fotomontage verändert werden.

Im letzten Schritt müssen die Verbindungen zur Massefläche durch sternförmige Anbindungen (Hitzefallen) hergestellt werden, was in Figur 4 für das Lötauge 5 gezeigt ist.

**Ansprüche**

1. Leiterplatte mit Signalleitungen und Versorgungsleitungen, dadurch gekennzeichnet, daß alle nicht für die Signalleitungen (1, 2) und Versorgungsleitungen benötigten Flächen mit einer Masseschicht (4) belegt sind.

2. Leiterplatte nach Anspruch 1, dadurch gekennzeichnet, daß die Signalleitungen (1, 2) und Versorgungsleitungen durch sie umgebende Trennfugen (6) in der Masseschicht (4) erzeugt sind.

0 283 566

Fig.1

Fig.2

Fig.3

Fig.4

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | E.D.N. ELECTRICAL DESIGN NEWS, Band 31, Nr. 5, März 1986, Seite 260, Boston, Massachusetts, US; N. BALAKRISHNANI: "Circuit and ground plane share one surface" <br> --- | 1,2 | H 05 K 1/00 |
| X | FR-A-2 137 991 (M.A. BRANDI) <br> * Anspruch 1; Figuren 1-10 * <br> --- | 1,2 | |
| X | US-A-4 363 930 (N.E. HOFFMAN) <br> * Spalte 3, Zeile 41 - Spalte 4, Zeile 14; Figur 1 * <br> --- | 1 | |
| A | US-A-4 130 723 (A.J. WAKELING) <br> * Spalte 1, Zeilen 26-41; Figuren 1,2 * <br> ------ | 1,2 | |

RECHERCHIERTE SACHGEBIETE (Int. Cl.4)

H 05 K 1/00
H 05 K 3/00
H 05 K 9/00

Der vorliegende Recherchenbericht wurde für alle Patentansprüche erstellt

| Recherchenort | Abschlußdatum der Recherche | Prüfer |
|---|---|---|
| BERLIN | 08-06-1988 | LEOUFFRE M. |